# EUROPÄISCHE PATENTSCHRIFT

(11) **EP 1 910 133 B1**
(45) Veröffentlichungstag und Bekanntmachung des Hinweises auf die Patenterteilung: **09.06.2010**
(21) Anmeldenummer: 06742231.1
(22) Anmeldetag: 10.04.2006
(51) Int. Cl.: B60R 16/02, H05K 5/00, F16H 61/00

(54) **STEUERGERÄT**
CONTROL DEVICE
APPAREIL DE COMMANDE

(30) Priorität: 15.04.2005 DE 102005017656
(43) Veröffentlichungstag der Anmeldung: 16.04.2008
(73) Patentinhaber: Conti Temic microelectronic GmbH, 90411 Nürnberg (DE)
(72) Erfinder: GRAMANN, Matthias, 91233 Neunkirchen a.S. (DE); HENNIGER, Jürgen, 91056 Erlangen-Dechsendorf (DE); WIECZOREK, Matthias, 91233 Neunkirchen a.S. (DE); GUTH, Peter, 90419 Nürnberg (DE)
(86) Internationale Anmeldenummer: PCT/DE2006/000630
(87) Internationale Veröffentlichungsnummer: WO 2006/108392

(56) Entgegenhaltungen:
- EP-A- 1 239 710
- DE-C1- 19 606 481
- US-A- 5 466 055
- US-A- 6 160 708

## Beschreibung

Die Erfindung betrifft ein Steuergerät nach dem Oberbegriff des Anspruchs 1.

Bei herkömmlichen Steuergeräten, wie sie beispielsweise in Getrieben von Kraftfahrzeugmotoren eingesetzt werden, ist die Anbringung der Sensoraufnahmen auf dem Gehäusedeckel nicht möglich, da der Deckel in der Regel nicht stabil ist und in Z-Richtung bei Druckschwankungen im Steuergerät keine zuverlässige Positionierung der Sensoraufnahmen zulässt. Deshalb werden die Sensoraufnahmen vorzugsweise außerhalb des Deckels auf einem separatem Kunststoffgehäuse positioniert, mit dem weiteren Nachteil, dass bei Temperaturschwankungen durch die verschiedenen Ausdehnungskoeffizienten von Kunststoffgehäuse und Gehäuseschale, meist aus Aluminium oder Grauguss, die Genauigkeit der Positionierung der Sensoraufnahmen in der X-Y-Ebene abnimmt. Außerdem wird dadurch der benötigte Bauraum relativ groB und dem Kundenwunsch, dass die durch die Sensoren zu sensierenden Teile in der Projektionsebene des Deckels liegen sollen, kann nicht entsprochen werden.

Ein derartiges Steuergerät ist aus der DE 197 12 842 C1 bekannt. Ein bevorzugtes Einsatzgebiet dieses Steuergerätes ist die Integration einer Steuerelektronik in ein Automatikgetriebe zur Realisierung einer vollintegrierten Getriebesteuerung. Das Steuergerät weist eine Grundplatte und einen Gehäusedeckel auf. Auf der Grundplatte ist eine Steuerelektronik angeordnet und eine am Gehäusedeckel umlaufende Dichtung dient zur Abdichtung des Steuergerätes gegenüber dem umgebenden Getriebeöl. Der Gehäusedeckel ist zudem als Trägerkörper für elektrische Leiter, Sensoren und Steckverbinder ausgebildet. Diese Komponenten liegen außerhalb des im Gehäusedeckel für die Aufnahme der Steuerelektronik ausgebildeten Hohlraumes. Zur elektrischen Verbindung der Steuerelektronik auf der Grundplatte mit den erwähnten außenliegenden Komponenten werden die elektrischen Leiter, zum Beispiel Stanzgitter, bei der Herstellung des Gehäusedeckels mit eingespritzt. Ein derartiges Steuergerät verursacht hohe Herstellungskosten, benötigt einen großen Bauraum und ist nach der Fixierung der elektrischen Leiter im Gehäusedeckel auf eine bestimmte Anwendung festgelegt. Ein ähnliches Steuergerät ist auch aus der DE 196 06 481 C1 bekannt.

Hiervon ausgehend liegt der vorliegenden Erfindung die Aufgabe zu Grunde, ein Steuergerät zu schaffen, das einen geringen Bauraum einnimmt und durch seinen modularen Aufbau flexibel einsetzbar ist und dadurch dazu beiträgt, die Herstellungskosten zu reduzieren.

Diese Aufgabe wird erfindungsgemäß gelöst durch ein Steuergerät mit den Merkmalen des Anspruchs 1.

Das Steuergerät befindet sich in einer Fluidumgebung und umfasst ein Gehäuse mit einem Gehäusedeckel zur Aufnahme von Sensoren und eine Gehäuseschale zur Aufnahme mindestens einer Steuereinheit. Zum elektrischen Verbinden der Sensoren mit der Steuereinheit ist mindestens ein Folienleiter vorgesehen, der zwischen dem Gehäusedeckel und einem Dichtelement angeordnet ist. Das Dichtelement ist flächig ausgebildet und dichtet die Gehäuseschale im Gegensatz zu einer umlaufenden Dichtung über die gesamte Fläche der Gehäuseschale gegen die Fluidumgebung ab.

Dadurch, dass die Sensoren auf dem Gehäusedeckel mit der Steuereinheit in der Gehäuseschale mittels eines Folienleiters elektrisch verbunden sind, kann zum Beispiel in der Vorserienphase sehr schnell auf eine Änderung in der Anordnung der Sensoren auf dem Gehäusedeckel reagiert werden. Es muss lediglich die Form des Folienleiters angepasst werden. Das flächige Dichtelement schließt die Gehäuseschale ganzflächig gegen das umgebende Fluid ab und hat den Vorteil, dass der Gehäusedeckel keine dichtende Funktion erfüllen muss und damit in seiner Formgebung weitestgehend unabhängig ist von der Kontur Gehäuseschale. Dieser modulare Aufbau des Steuergerätes hat zur Folge, das es möglich ist, das Steuergerät in verschiedenen Brennkraftmaschinen einzusetzen, indem einfach ein anderer Gehäusedeckel mit einer angepassten Sensoranordnung und Folienleiterform zur Anwendung kommt.

Die Verwendung eines zusammenhängenden Folienleiters erlaubt eine einfache Leitungsführung und erleichtert das Handling bei der Montage, da nur ein Teil verwendet wird.

Die selben Vorteile in bezug auf das Handling bei der Montage ergeben sich bei der Ausführung des flächigen Dichtelements aus einem Stück.

Vorzugsweise ist das flächige Dichtelement flexibel ausgeführt. Dadurch können beim Auftreten selbst extremer Temperaturschwankungen im Steuergerät auftretende Druckschwankungen ohne Beeinträchtigung der Dichtfunktion kompensiert werden.

Die Aufnahmen der Sensoren sind auf der der Gehäuseschale abgewandten Seite des Gehäusedeckels angeordnet; insbesondere derart, dass sie auch Signale von Motorbauteilen, wie zum Beispiel Getriebezahnräder, abnehmen können, die außerhalb des Steuergerätes in einem Bereich gelegen sind, der sich innerhalb der Projektionsebene der Steuerelektronik befindet.

Um den Aufwand zum Abdichten so gering wie möglich zu halten, ist vorzugsweise nur der Teil der Gehäuseschale, der die mindestens eine Steuereinheit aufnimmt, gegen die Fluidumgebung abgedichtet. Insbesondere ist in der Gehäuseschale in diesem entsprechenden Bereich zusätzlich eine umlaufende Dichtung vorgesehen

Vorteilhafterweise sind der Gehäusedeckel und die Gehäuseschale aus dem selben Material , zum Beispiel aus Aluminium oder Grauguss hergestellt. Bei der Verwendung von verschiedenen Materialien würde bei Temperaturschwankungen die durch die verschiedenen Ausdehnungskoeffizienten verursachte unterschiedliche Längenausdehnung der beiden Teile eine exakte Positionierung der Sensoren nicht zulassen.

Um bei Unterdruck in der Gehäuseschale, bedingt durch eine Temperaturänderung in der Fluidumgebung, ein Einsinken des flächigen Dichtelements und damit verbunden ein Berühren der Steuerelektronik oder sonstiger elektronischer Bauteile durch das Dichtelement zu verhindern, ist das Dichtelement zumindest punktuell kraft- und/oder formschlüssig mit dem Gehäusedeckel verbunden. Diese punktuelle Verbindung kann durch Verhaken oder Verstemmen des Dichtelements im Gehäusedeckel bewerkstelligt werden.

Das flächige Dichtelement weist Dome auf, die durch Durchbrüche im Folieneiter in entsprechende Vertiefungen im Gehäusedeckel ragen. Dadurch ist eine einfache Führung und Fixierung des Folienleiters zwischen der flächigen Dichtung und dem Gehäusedeckel gewährleistet. Denkbar wäre auch, dass die Dome am Gehäusedeckel angeordnet sind, und in entsprechende Vertiefungen im flächigen Dichtelement ragen.

In der nachfolgenden Beschreibung werden die vorteilhaften Merkmale und Einzelheiten der Erfindung in Zusammenhang mit den beigefügten Zeichnungen anhand von Ausführungsbeispielen näher erläutert. Dabei sind in einzelnen Varianten beschriebene Merkmale und Zusammenhänge grundsätzlich auf alle Ausführungsbeispiele übertragbar. In den Zeichnungen zeigen:
Fig. 1 ein Steuergerät mit abgelöster Ventilkontaktierung in Explosionsdarstellung
Fig. 2 ein Steuergerät mit integrierter Ventilkontaktierung in Explosionsdarstellung

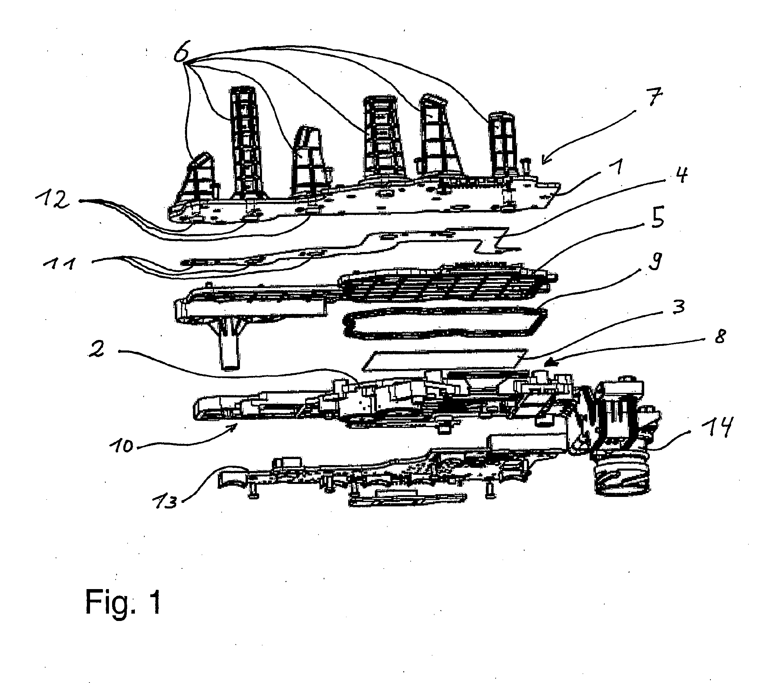

Fig. 1 zeigt ein Steuergerät wie es zum Beispiel zum Steuern von Aktoren in Kraftfahrzeuggetrieben eingesetzt wird. Das Steuergerät sitzt ganz oder nur teilweise im Getriebeöl und umfasst einen Gehäusedeckel 1 und eine Gehäuseschale 2 . Das Steuergerät ist während des Betriebes Temperaturschwankungen in einem Bereich von ca. -40° C bis + 150°C ausgesetzt. Weitere ungünstige äußere Einflüsse sind vor allem temperaturwechselbedingte Druckschwankungen innerhalb und außerhalb des Steuergerätes, mechanische Kräfte durch umströmendes Öl und Vibrationen, die insbesondere durch den Motor hervorgerufen werden.

Auf der der Gehäuseschale 2 abgewandten Seite 7 des Gehäusedeckels 1 sind die Aufnahmen 6 für die Sensoren je nach Lage der zu sensierenden Getriebekomponenten angeordnet. Die zu sensierenden Getriebekomponenten sind zum Beispiel Getriebezahnräder, deren Umdrehungszahl bestimmt werden soll, oder auch Schaltgabeln zur Bestimmung der Schaltstufen. Die in Fig. 1 gezeigten Sensoraufnahmen 6 sind säulenförmige Gebilde aus Kunststoff. Sie sind vorzugsweise von der den Sensoraufnahmen 6 gegenüber liegenden Seite her durch entsprechende, nicht gezeigte Öffnungen im Gehäusedeckel 1 mit dem Gehäusedeckel 1 verschraubt.

Die Sensoren sitzen sehr passgenau in den entsprechenden Sensoraufnahmen 6. Der Gehäusedeckel 1, als Basis für die Sensoraufnahmen 6, muss insbesondere deren genaue Positionierung in X-, Y- und Z-Richtung gewährleisten. Der Gehäusedeckel 1 ist deshalb insbesondere als steife, stabile Platte, vorzugsweise aus Aluminium oder Stahl, ausgeführt. Der Vorteil gegenüber einem Druckgussteil sind außerdem die niedrigen Material- und Herstellungskosten. Der Gehäusedeckel 1 ist so stabil, dass Druck- bzw. Temperaturschwankungen keine Lageänderung der Sensoraufnahmen 6 zur Folge haben. Beispielsweise können Druckschwankungen im Gehäuse von - 400 mbar bis + 700 mbar um den Normaldruck ohne negative Einflüsse auf die Lage der Sensoraufnahmen 6 aufgefangen werden.

Als elektrische Kontaktierung der Sensoren durch den Gehäusedeckel 1 hindurch dient zum Beispiel ein in die Sensoraufnahmen 6 eingespritztes Stanzgitter. An dem dem Sensor gegenüberliegenden Ende der Sensoraufnahme 6 ragt das Stanzgitter so weit aus der Sensoraufnahmen 6 heraus, dass nach dem elektrisch isolierenden Hindurchführen des Stanzgitters durch die entsprechende Öffnung im Gehäusedeckel 1 eine Kontaktierung des Stanzgitters von der Gehäuseschalenseite her möglich ist. Die Durchführung der Kontaktierung muss nicht öldicht ausgeführt sein. Das Stanzgitter ist in der Fig. 1 nicht im Detail gezeigt.

Zur elektrischen Verbindung der Sensoren mit der Steuereinheit 3 in der Gehäuseschale 2 dient ein zusammenhängender, einstückiger Folienleiter 4. Denkbar sind auch einzelne, je nach Sitz der Sensoraufnahmen 6 angeordnete Folienstreifen. Um Material zu sparen, ist die Form des Folienleiters 4 an die Anordnung der Sensoraufnahmen 6 angepasst. Ändert sich zum Beispiel in der Entwicklungsphase des Getriebes die Lage der zu sensierenden Getriebekomponenten, so kann ohne große zeitliche Verzögerung die Anordnung der Sensoraufnahmen 6 und dementsprechend die Form des Folienleiters 4 angepasst werden. Denkbar wäre auch, die selbe Steuereinheit in verschiedenen Getriebeausführungen zu verwenden. Zudem ist der Folienleiter 4 resistent gegen das aggressive Getriebeöl. Der Folienleiter 4 ist vorzugsweise auf den Gehäusedeckel 1 auflaminiert.

Die Gehäuseschale 2 mit der Steuereinheit 3 wird durch ein flächiges Dichtelement 5 aus Kunststoff im gesamten Temperatur- und Druckschwankungsbereich ohne zusätzliche Druckausgleichsvorrichtung ganzflächig gegen das Getriebeöl abgedichtet. Das flächige Dichtelement 5 besteht vorzugsweise aus einem Stück. Der Kunststoff kann zum Beispiel ein vernetztes Polymer sein. Das flächige Dichtelement 5 ist so zwischen dem Gehäusedeckel 1 und der Gehäuseschale 2 angeordnet, dass die Toleranz in der Abmessung des Steuergeräts in Richtung der Längsachse der Sensoraufnahmen nicht beeinflusst wird.

Der Folienleiter 4 ist zwischen dem Gehäusedeckel 1 und flächigen Dichtelement 5 angeordnet. Wenn der Folienleiter 4 nicht flächig mit dem Gehäusedeckel 1 verbunden ist, so kann er zum Beispiel, wie in Fig. 1 gezeigt, dadurch geführt und fixiert werden, dass die Dome 12, die am Gehäusedeckel 1 angeordnet sind, durch entsprechende Durchbrüche 11 im Folienleiter 4 in entsprechende Vertiefungen im flächigen Dichtelement 5 eingeführt werden. Es wäre auch denkbar, dass die Dome auf dem flächigen Dichtelement 5 und die entsprechenden Vertiefungen auf dem Gehäusedeckel - 1 angeordnet sind. Durch diese Anordnung wird der Folienleiter 4 vor allem auch gegen im Betrieb auftretende dynamische Ölkräfte lagestabil gehalten. Ein weiterer Vorteil des flächigen Dichtelements 5 ist, dass der Gehäusedeckel 1 selbst keine Dichtfunktion haben muss.

Das flächige Dichtelement 5 kann insbesondere als flexible Membran ausgeführt sein. Dadurch können auch größere Druckschwankungen in der Gehäuseschale 2 ohne Beeinträchtigung der Dichtfunktion kompensiert werden. Bei Unterdruck in der Gehäuseschale 2 wird ein Einsinken der Membran 5 und damit ein eventuelles Berühren von Bauteilen oder elektrischen Verbindungen, wie Bonddrähten, auf der Steuereinheit 3 in der Gehäuseschale 2 oder gar deren Beschädigung, dadurch verhindert, dass die Membran 5 mit dem Gehäusedeckel 1 zumindest punktuell kraft- und/oder formschlüssig verbunden ist. Dies kann zum Beispiel durch verhaken oder verstemmen der Membran 5 im Gehäusedeckel 1 erfolgen. Bei Überdruck in der Gehäuseschale 2 wird die Membran 5 gegen den Gehäusedeckel 1 gedrückt und so eine sich auf die Dichtfunktion negativ auswirkende Dehnung der Membran 5 vermieden.

Unter extremen Bedingungen kann es erforderlich sein, dass der Teil 8 der Gehäuseschale 2, der die Steuereinheit 3 aufnimmt, durch eine zusätzliche, umlaufende Dichtung 9 gegen die Fluidumgebung abgedichtet ist. Das Material aus dem diese Dichtung 9 gefertigt ist, kann zum Beispiel ein vernetztes Polymer sein.

Fig. 1 zeigt, dass die Gehäuseschale 2 im wesentlichen den Teil 8, der die Steuereinheit 3 aufnimmt, und den Teil 10 umfasst. Der Teil 10 der Gehäuseschale 2 hat insbesondere eine Montagefunktion. Das Steuergerät wird insbesondere mittels dieses Teils 10 zum Beispiel am Getriebe befestigt. Der Gehäusedeckel 1 und das flächige Dichtelement 5 haben im wesentlichen die selben flächigen Ausdehnungen wie die Gehäuseschale 2. Es ist aber auch denkbar, das flächige Dichtelement 5 kleiner zu dimensionieren, und zwar zum Beispiel dergestalt, dass es nur den Teil 8 der Gehäuseschale 2 mit der Steuereinheit 3 abdichtet.

Die Form des Gehäusedeckels 1 hängt vor allem von der Lage der Sensoraufnahmen 6 ab. Liegen beispielsweise die Sensoraufnahmen 6 nur im Bereich der Projektionsebene des Teils 8, so kann der Deckel 1 auch materialsparend entsprechend auf diesen Bereich beschränkt ausgeführt werden.

Fig. 1 zeigt zusätzlich die Ventilkontaktierung 13 im unmontierten Zustand. Sie wird vorzugsweise durch Verschrauben mit der Gehäuseschale 2 verbunden. Über den Stecker 14 erfolgt die elektrische Verbindung zwischen der Steuereinheit 3 und der Motorperipherie, wie zum Beispiel dem Motorsteuergerät. Der Stecker 14 ist form- oder kraftschlüssig mit der Gehäuseschale 2 verbunden.

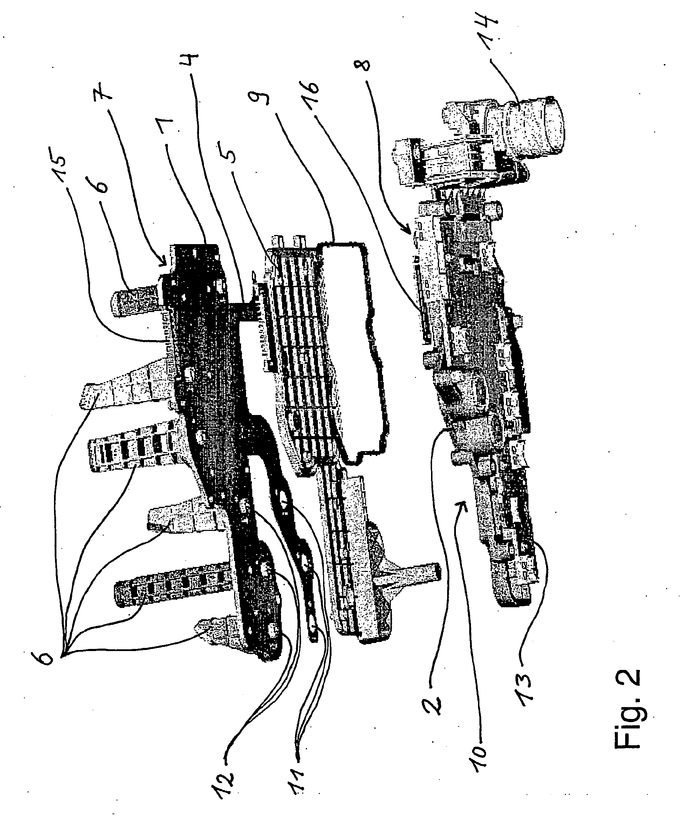

Fig. 2 zeigt das Steuergerät wie in Fig. 1, nur dieses Mal mit am Gehäusedeckel 2 integrierter Ventilkontaktierung 13 und einer bereits in die Gehäuseschale 2 eingesetzten Steuereinheit 3. Die in der Fig. 2 gezeigte erste Schnittstelle 15 ist form- und/oder kraftschlüssig mit dem Gehäusedeckel 1 verbunden. Sie dient zur elektrischen Verbindung des Folienleiters 4 mit einem weiteren Folienleiter, der hier nicht eingezeichnet ist. Ausgehend von der ersten Schnittstelle 15 am Gehäusedeckel 1 verläuft dieser weitere Folienleiter außerhalb des abzudichtenden Teils 8 der Gehäuseschale zur zweiten Schnittstelle 16. Diese zweite Schnittstelle 16 ist beispielsweise dichtend durch die Gehäuseschale 2 hindurch elektrisch mit der Steuereinheit 3 verbunden. Die elektrische Verbindung der ersten bzw. zweiten Schnittstelle 15 bzw. 16 mit dem weiteren Folienleiter kann zum Beispiel durch Löten und/oder Einpresskontaktierung erfolgen. Ist ein Auswechseln des Gehäusedeckels 2 erforderlich, zum Beispiel auf Grund einer geänderten Lage der Sensoraufnahmen 6, muss lediglich die Verbindung zwischen der Schnittstelle 15 und dem weiteren Folienleiter gelöst werden. Dies ist ein weitere Vorteil des modularen Aufbaus diese Steuergeräts.

Das vorliegende Steuergerät, das sich vor allem durch seine Stabilität, durch seinen modularen Aufbau und seine Kompaktheit auszeichnet, ist kostengünstig herzustellen und flexibel einsetzbar. Der Gehäusedeckel hat keine Dichtfunktion. Somit kann für die selbe Gehäuseschale mit Steuereinheit der Gehäusedeckel mit den Sensoraufnahmen und dem entsprechenden Folienleiter an verschiedene Getriebe angepasst werden.

### Bezugszeichenliste:

- 1: Gehäusedeckel
- 2: Gehäuseschale
- 3: Steuereinheit
- 4: Folienleiter
- 5: Flächiges Dichtelement
- 6,: Sensoraufnahmen
- 7: Oberseite des Gehäusedeckels
- 8: Teil der Gehäuseschale, der die Steuereinheit aufnimmt
- 9: Umlaufende Dichtung
- 10: Teil der Gehäuseschale, dient der Montage
- 11: Durchbruch im Folienleiter
- 12: Dom im Gehäusedeckel
- 13: Ventilkontaktierung
- 14: Stecker
- 15: Erste Schnittstelle, am Gehäusedeckel
- 16: Zweite Schnittstelle, an der Steuereinheit

## Patentansprüche

1. Steuergerät in einer Fluidumgebung mit einem Gehäuse, umfassend einen Gehäusedeckel (1) zur Aufnahme von Sensoren und eine Gehäuseschale (2) zur Aufnahme mindestens einer Steuereinheit (3), mit mindestens einer Einrichtung (4) zum elektrischen Verbinden der Sensoren mit der Steuereinheit und mit mindestens einem Dichtelement (5) zur Abdichtung der Gehäuseschale (2) gegen die Fluidumgebung, **dadurch gekennzeichnet, dass**
- die Einrichtung (4) zum elektrischen Verbinden der Sensoren auf dem Gehäusedeckel (1) mit der Steuereinheit (3) in der Gehäuseschale (2) als Folienleiter zwischen dem Gehäusedeckel (1) und dem Dichtelement (5) ausgebildet ist und dass
- das Dichtelement (5) als flächiges Dichtelement ausgebildet ist.

2. Steuergerät nach Anspruch 1, **dadurch gekennzeichnet, dass** der Folienleiter (4) als zusammenhängender Folienleiter ausgebildet ist.

3. Steuergerät nach Anspruch 1 oder 2 , **dadurch gekennzeichnet, dass** das flächige Dichtelement (5) einstückig ausgebildet ist.

4. Steuergerät nach einem der vorherigen Ansprüche, **dadurch gekennzeichnet, dass** das flächige Dichtelement (5) flexibel ausgeführt ist.

5. Steuergerät nach einem der vorherigen Ansprüche, **dadurch gekennzeichnet, dass** die Aufnahmen (6) der Sensoren auf der der Gehäuseschale (2) abgewandten Seite (7) des Gehäusedeckels (1) angeordnet sind.

6. Steuergerät nach einem der vorherigen Ansprüche, **dadurch gekennzeichnet, dass** der Teil (8) der Gehäuseschale (2), der die mindestens eine Steuereinheit (3) aufnimmt, gegen die Fluidumgebung abgedichtet ist.

7. Steuergerät nach Anspruch 6, **dadurch gekennzeichnet, dass** der Teil (8) der Gehäuseschale (2), der die mindestens eine Steuereinheit (3) aufnimmt, mit einer umlaufenden Dichtung (9) gegen die Fluidumgebung abgedichtet ist.

8. Steuergerät nach einem der vorherigen Ansprüche , **dadurch gekennzeichnet, dass** Gehäusedeckel (1) und Gehäuseschale (2) aus identischem Material sind.

9. Steuergerät nach Anspruch 8, **dadurch gekennzeichnet, dass** der Gehäusedeckel (1) und die Gehäuseschale (2) aus Aluminium, Stahlblech oder Grauguss sind.

10. Steuergerät nach einem der vorherigen Ansprüche, **dadurch gekennzeichnet, dass das** flächige Dichtelement (5) wenigstens punktuell kraft- und/oder formschlüssig mit dem Gehäusedeckel (1) verbunden ist.

11. Steuergerät nach Anspruch 10, **dadurch gekennzeichnet, dass** das flächige Dichtelement (5) durch Verhaken oder Verstemmen mit dem Gehäusedeckel (1) wenigstens punktuell verbunden ist.

12. Steuergerät nach einem der vorherigen Ansprüche, **dadurch gekennzeichnet, dass** das flächige Dichtelement (5) Dome aufweist, die durch Durchbrüche (11) im Folienleiter (4) in entsprechende Vertiefungen im Gehäusedeckel (1) ragen.

13. Steuergerät nach einem der Ansprüche 1 bis 11, **dadurch gekennzeichnet, dass** der Gehäusedeckel (1) Dome (12) aufweist, die durch Durchbrüche (11) im Folieneiter (4) in entsprechende Vertiefungen im flächigen Dichtelement (5) ragen.

## Claims

1. A control device in a fluid environment with a housing, comprising a housing lid (1) for retaining sensors and a housing frame (2) for retaining at least one control unit (3) with at least one device (4) for the electric connection of the sensors with the control unit and at least one sealing element (5) for sealing the housing frame (2) against the fluid environment, **characterized in that**
- the device (4) for the electric connection of the sensors on the housing lid (1) with the control unit (3) in the housing frame (2) is designed as a foil conductor between the housing lid (1) and the sealing element (5), and that
- the sealing element (5) is designed as a two-dimensional sealing element.

2. A control device according to claim 1, **characterized in that** the foil conductor (4) is designed as a continuous foil conductor.

3. A control device according to either of claims 1 or 2, **characterized in that** the two-dimensional sealing element (5) is designed as a single piece.

4. A control device according to any one of the preceding claims, **characterized in that** the two-dimensional sealing element (5) is designed to be flexible.

5. A control device according to any one of the preceding claims, **characterized in that** the retainers (6) of the sensors are arranged on the side (7) of the lid (1) which faces away from the housing frame (2).

6. A control device according to any one of the preceding claims, **characterized in that** the part (8) of the housing frame (2) which retains the at least one control unit (3) is sealed against the fluid environment.

7. A control device according to claim 6, **characterized in that** the part (8) of the housing frame (2) which retains the at least one control unit (3) is sealed with a circumferential seal (9) against the fluid environment.

8. A control device according to any one of the preceding claims, **characterized in that** the housing lid (1) and the housing frame (2) are made of an identical material.

9. A control device according to claim 8, **characterized in that** the housing lid (1) and the housing frame (2) are made of aluminium, sheet steel or cast iron.

10. A control device according to any one of the preceding claims, **characterized in that** the two-dimensional sealing element (5) is connected at least punctiformly in a force-fit and/or form-fit manner with the housing lid (1).

11. A control device according to claim 10, **characterized in that** the two-dimensional sealing element (5) is at least punctiformly connected with the housing lid (1) by catching or caulking.

12. A control device according to any one of the preceding claims, **characterized in that** the two-dimensional sealing element (5) comprises domes which protrude through openings (11) in the foil conductor (4) into corresponding recesses in the housing lid (1).

13. A control device according to any one of claims 1 to 11, **characterized in that** the housing lid (1) comprises domes (12) which protrude through openings (11) in the foil conductor (4) into corresponding recesses in the two-dimensional sealing element (5).

## Revendications

1. Appareil de commande dans un environnement fluide avec un boîtier, comprenant un couvercle de boîtier (1) pour l'accueil de capteurs et une coque de boîtier (2) pour l'accueil d'au moins une unité de commande (3), avec au moins une installation (4) pour la connexion électrique des capteurs avec l'unité de commande et avec au moins un élément d'étanchéité (5) pour l'étanchéification de la coque de boîtier (2) vis-à-vis de l'environnement fluide, **caractérisé en ce que**
- l'installation (4) pour la connexion électrique des capteurs sur le couvercle de boîtier (1) avec l'unité de commande (3) dans la coque de boîtier (2) est formée comme conducteur film entre le couvercle de boîtier (1) et l'élément d'étanchéité (5) et **en ce que**
- l'élément d'étanchéité (5) est formé comme élément d'étanchéité étendu.

2. Appareil de commande selon la revendication 1, **caractérisé en ce que** le conducteur film (4) est formé comme conducteur film continu.

3. Appareil de commande selon la revendication 1 ou 2, **caractérisé en ce que** l'élément d'étanchéité (5) étendu est formé d'une seule pièce.

4. Appareil de commande selon l'une des revendications précédentes, **caractérisé en ce que** l'élément d'étanchéité (5) étendu est réalisé de façon souple.

5. Appareil de commande selon l'une des revendications précédentes, **caractérisé en ce que** les logements (6) des capteurs sont disposés sur le côté (7) du couvercle de boîtier (1) opposé à la coque de boîtier (2).

6. Appareil de commande selon l'une des revendications précédentes, **caractérisé en ce que** l'élément (8) de la coque de boîtier (2) qui accueille l'au moins une unité de commande (3) est étanchéifié vis-à-vis de l'environnement fluide.

7. Appareil de commande selon la revendication 6, **caractérisé en ce que** l'élément (8) de la coque de boîtier (2) qui accueille l'au moins une unité de commande (3) est étanchéifié vis-à-vis de l'environnement fluide par un joint (9) périphérique.

8. Appareil de commande selon l'une des revendications précédentes, **caractérisé en ce que** le matériau du couvercle de boîtier (1) et le matériau de la coque de boîtier (2) sont identiques.

9. Appareil de commande selon la revendication 8, **caractérisé en ce que** le couvercle de boîtier (1) et la coque de boîtier (2) sont en aluminium, en tôle d'acier ou en fonte grise.

10. Appareil de commande selon l'une des revendications précédentes, **caractérisé en ce que** l'élément d'étanchéité (5) étendu est joint avec le couvercle de boîtier (1) par liaison de force et/ou par liaison de forme, au moins ponctuellement.

11. Appareil de commande selon la revendication 10, **caractérisé en ce que** l'élément d'étanchéité (5) étendu est joint avec le couvercle de boîtier (1) par accrochage ou par matage, au moins ponctuellement.

12. Appareil de commande selon l'une des revendications précédentes, **caractérisé en ce que** l'élément d'étanchéité (5) étendu présente des dômes, lesquels pénètrent dans des cavités correspondantes dans le couvercle de boîtier (1), par des passages (11) dans le conducteur film (4).

13. Appareil de commande selon l'une des revendications 1 à 11, **caractérisé en ce que** le couvercle de boîtier (1) présente des dômes (12), lesquels pénètrent dans des cavités correspondantes dans l'élément d'étanchéité (5) étendu, par des passages (11) dans le conducteur film (4).
